# EUROPEAN PATENT APPLICATION

(11) **EP 0 599 605 A2**
(43) Date of publication of application: **01.06.1994**
(21) Application number: 93309339.5
(22) Date of filing: 23.11.1993
(51) Int. Cl.: H03K 17/08

(54) **Semiconductor device with current-sensing function**

(30) Priority: 25.11.1992 JP 313825/92
(71) Applicant: FUJI ELECTRIC CO. LTD., Kawasaki 210 (JP)
(72) Inventor: Housen, Toru, Matsumoto City, Nagano 399 (JP); Watanabe, Manabu, Matsumoto City, Nagano 390 (JP)
(74) Representative: Topley, Paul

(57) **Abstract**

This disclosure relates to an overcurrent protection means in a semiconductor device consisting of a semiconductor element (1, 6) with a current-sensing function and its control circuit (2), wherein the semiconductor element (1) has two current-sensing electrodes (1b, 1d) to output sensing currents (1e, 1f) that are proportional to the main current (6f), the sensing currents (1e, 1f) output from the sensing electrodes (1b, 1d) flow into separate current-sensing resistors (72, 72a), where the current detection voltages (V6, V6a), which are proportional to the sensing currents (1e, 1f), consequently proportional to the main current (6f), are generated in each resistor (72, 72a), and by structuring the circuitry so that the detection voltages (V6, V6a) are independently applied to the main current turn-off command circuit (74) and the main current control circuit (75) in the control circuit (2), an overcurrent detection level (I oc) of the main current and a short-circuit current detection level (I sct) can be set independently of each other.

## Description

The present invention relates to a semiconductor device that uses a semiconductor element with a current-sensing function, which are now widely applied in the area of power electronics equipment, for example, in inverter devices and servo-motor driving devices.

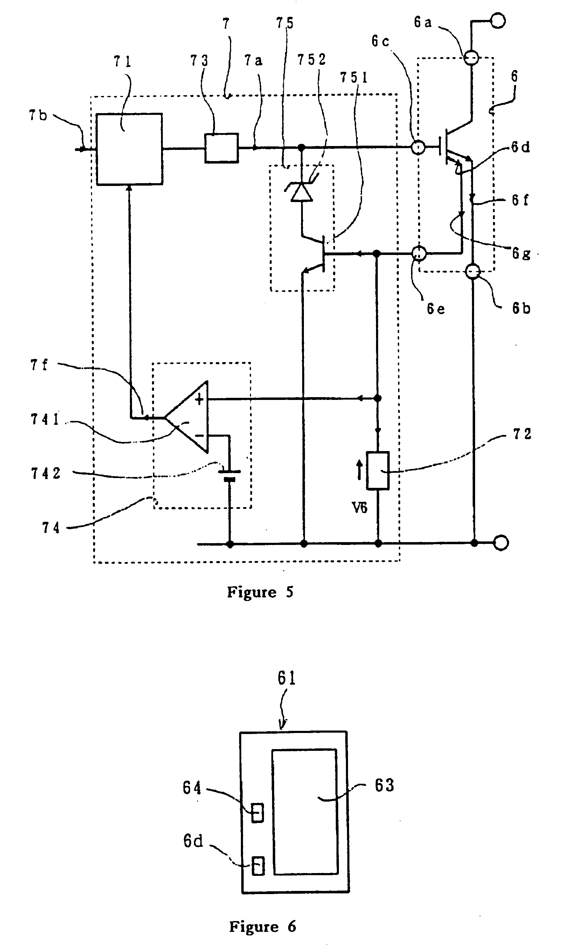

A circuit diagram of the major part of a conventional semiconductor device that uses a semiconductor element with a current sensing function is seen in Figure 5 of the accompanying drawings.

In Figure 5, an IGBT 6 with a sensing function, which is one example of a semiconductor element with a current sensing function, is shown with a control circuit 7.

The IGBT 6 has a collector terminal 6a acting as a main electrode, an emitter terminal 6b, acting as another main electrode, a gate terminal 6c acting as a control electrode, and an output terminal 6e for the current-sensing electrode 6d. This IGBT turns the device on and off according to a drive signal 7a emitted from a control circuit 7, which causes a main current 6f to flow from the terminal 6a to the terminal 6b when the device is turned on, and turns the main current 6f off when the drive signal 7a received is a turn-off signal.

When the main current 6f flows into the IGBT 6, a sensing current 6g with a value proportional to the main current 6f flows from the sensing electrode 6d, and this current can be led from the output terminal 6e externally of the IGBT 6.

A plan view of the construction of the aforementioned IGBT 6 is shown in Figure 6. The IGBT 6 has an emitter 63 with a large area formed on the surface of a semiconductor substrate 61, while the surface that includes this emitter also includes a gate 64 and a current-sensing electrode 6d with an area that is substantially smaller than that of the emitter 63. The collector is formed on the face opposite the face which has the emitter 63.

The control circuit 7 consists of a drive circuit 71, a current-sensing resistor 72, a gate resistor 73 disposed as required, a main current turn-off command circuit 74, and a main current control circuit 75.

The drive circuit 71 takes as its inputs an action command signal 7b provided by an earlier stage control circuit, which is not shown, and an operation stop command signal 7f provided by the main current turn-off command circuit 74, and provides the drive signal 7a to turn the IGBT 6 on and off normally according to said signal 7b via the gate resistor 73.

In addition, when said signal 7f is present, the drive circuit 71 makes said signal 7a a turn-off signal for the IGBT 6 regardless of what the command calls for, and makes the voltage between the emitter and the gate nearly zero, which turns the IGBT 6 off.

The current-sensing resistor 72 has a resistance value Rs and generates a detection voltage V6 which is proportional to the flowing sensing current 6g and is consequently proportional to the main current 6f.

The main current turn-off command circuit 74 includes a comparator 741 and a reference voltage source 742, which provides a reference voltage E1 used to make determinations in the comparator 741. Said reference voltage E1 is selected at a voltage value that is higher than the detection voltage V6 which corresponds to the value of the main current 6f when the IGBT 6 is operating normally.

If the value of said detection voltage V6 exceeds the reference voltage E1, the main current turn-off command circuit 74 assumes that an excessive current is flowing into the IGBT 6, and emits the signal 7f.

The main current control circuit 75 consists of an NPN transistor 751 and a constant voltage diode 752 with its anode connected to the collector of the transistor 751, the base of the transistor 751 being subject to the input of said detection voltage V6.

If the value of the detection voltage V6 rises above the value of said reference voltage E1, and also exceeds the threshold voltage V th of the transistor 751, then the transistor 751 turns on, while the voltage between the gate and the emitter of the IGBT 6 is reduced to the Zener voltage value of the constant voltage diode 752.

As described above, in the control circuit 7 shown in Figure 5, which is an example of a conventional device, the IGBT 6 turns the device on and off according to the turn-on and turn-off command signals 7a provided by the drive circuit 71, which receives the action command signal 7b. When a high H level signal 7a is received, a turn-on command signal occurs and the IGBT turns on to supply the main current 6f to a load device (not shown). When a low L level signal 7a is received, a turn-off command signal occurs and the IGBT turns off to stop supplying the main current 6f to the load device.

If the signal 7a is a turn-on command signal, and the value of the main current 6f increases for some reason, thereby causing the value of the detection voltage V6 generated by the current-sensing resistor 72 to exceed the reference voltage E1 of transistor 751, then the main current turn-off command circuit 74 detects this condition and applies its output signal 7f to the drive circuit 71. The drive circuit 71, when the signal 7f is received, then switches the output signal 7a to the low L level signal and forces the IGBT 6 to go off.

However, if the value of the main current 6f increases abruptly as a result of the short circuiting of the load device, the signal transmitted from the main current turn-off command circuit 74 to the IGBT 6 via the drive circuit 71 cannot follow the sharp increase in the main current 6f because of the time delay in the signal transmission along the transmission path, and thus during this time an excessive current may continue flowing into the IGBT 6.

In such a situation, the main current control circuit 75, which has a higher response speed, detects the sharp increase in the main current, and sends its output signal directly to terminal 6c of the IGBT 6 without going through the drive circuit 71. This quickly reduces the main current 6f to a value that the IGBT 6 can tolerate.

The main current decreased condition lasts until the IGBT 6 turns off according to the turn-off command signal from the drive circuit 71, which subsequently receives the signal 7f from the main current turn-off command circuit 74.

By the above-described operation, the IGBT 6 and its load device are protected from excessive levels of the main current 6f, making it possible to operate the system properly.

Below, the values of the main current 6f when respective output signals are issued with respect to the aforementioned main current turn-off command circuit 74 and the main current control circuit 75 shown in Figure 5, are explained.

The value of the main current 6f obtained when the main current turn-off command circuit 74 issues an overcurrent detection signal 7f, which is the value at the overcurrent detection level, is noted as I oc, the value of the sensing current 6g at this time is noted as i oc, the ratio between the two current values is noted as N, the resistance value in the current-sensing resistor 72 is noted as Rs, and the reference voltage used to compare signals is noted as E1. In this way, the following formula 1 can be expressed:$\text{E1 = (i oc) Rs}$$\text{i oc = (I oc)/N}$$\text{I oc = (N) (E1)/Rs}$

If the value of the main current 6f obtained when the NPN transistor 751 turns on and then the main current control circuit 75 issues its short circuit current detection signal (i.e. the value at the short-circuit current detection level) is noted as I sct, the value of the sensing current 6g at this time is noted as i sct, and the threshold voltage for the transistor 751 is noted as V th, then the following formulae 2 can be formulated:$\text{V th = (i sct) Rs}$$\text{i sct = (I sct)/N}$$\text{therefore I sct = (N) (V th)/Rs}$

In other words, because the conventional control circuit 7 commonly uses the detection voltage V6 generated by the sensing current 6g at the resistor 72 as the input signals for the main current turn-off command circuit 74 and the main current control circuit 75, with the former acting according to formula 1 and the latter acting according to formula 2, then the ratio I oc/I sct of these two current values is equivalent to the ratio E1/V th of the two voltage values.

Therefore, once the reference voltage E1 and threshold voltage V th are determined, neither the sensing current value at overcurrent detection, I oc, or the value of the main current when a short circuit is detected I sct, can be set independently any longer.

For this reason, if the current value I oc, is increased so that a device may be used with the main current 6f up to a certain large value, then the current value I sct must also be increased. If the main current 6f increases suddenly because of a short circuit or some other failure, the IGBT 6 will be subjected to the risk of a current breakdown.

The purpose of the present invention is to solve the above technical problems by providing a semiconductor device that can set the two current values, I oc and I sct, independently of each other.

As is clear from the above, in the operation of a main current turn-off command circuit and a main current control circuit which protect semiconductor elements from excessive main currents in a semiconductor device consisting of a semiconductor element with a current-sensing function and a control circuit, wherein the detection voltage V6 generated in the current-sensing resistor 72 as a current detection signal is applied to the two aforementioned protective circuits, it has not been possible to set the current value, I oc, at an overcurrent detection level and the current value, I sct, at a short circuit current detection level independently of each other in the conventional circuitry shown in Figure 5.

The present invention aims to solve these conventional problems using the following structured characteristics:
1. The circuitry is so structured that various current-sensing electrodes are disposed on a semiconductor element with a current-sensing function, wherein the detection signals for each of the sensing currents derived from each of the current-sensing electrodes are applied independently into the main current turn-off command circuit and main current control circuit.
   To generate detection signals for each of the currents in this case, current-sensing resistors, which can generate detection voltages that are proportional to the current when the sensing current is flowing, are disposed for each sensing current, while the required resistance values for these resistors are individually selected, so that the two current values, I oc and I sct, can be set independently of each other.
2. The circuitry is so structured that the sensing current derived from the current-sensing electrodes on the semiconductor element with a current-sensing function flows into the current sensing resistors, where the voltage signals generated by the sensing current in the resistors are divided at a predetermined ratio, and two sets of the divided voltage thereby derived are independently applied to the main current turn-off command circuit and main current control circuit.
   In this case, the current-sensing resistor is constructed with various unit resistors connected to each other in series so that the required divided voltages can be obtained from the connecting points of each unit resistor constituting resistance ratios corresponding to the voltage division ratios. Therefore, by individually selecting the voltage ratios, the two current values, I oc and I sct, can be set independently of each other.
3. The circuitry is so structured that, when the various semiconductor elements with a current-sensing function are connected in parallel, the current-sensing electrodes corresponding to these semiconductor elements are also connected in parallel, thereby generating a total current of the sensing currents from each sensing electrode. The current detection signals obtained from passing this total current into the current-sensing resistors as described in Items 1 and 2 above are applied independently into the main current turn-off command circuit and main current control circuit, respectively.
   In this case, the parallel-connected semiconductor elements are protected against overcurrent, that is, against the total main current.

Embodiments of the invention will now be described in detail with reference to the accompanying drawings, in which:
Figure 1 is a circuit diagram of the principal relevant part of a semiconductor device according to a first embodiment of the present invention;
Figure 2 is a plan view showing the construction of the semiconductor element with a current-sensing function that is shown in Figure 1;
Figure 3 is a circuit diagram of the principal relevant part of a semiconductor device according to a second embodiment of the present invention;
Figure 4 is a circuit diagram of the principal relevant part of a semiconductor device according to a third embodiment of the present invention;
Figure 5 is a circuit diagram of the principal relevant part of a conventional semiconductor device; and
Figure 6 is a plan view showing the construction of the semiconductor element shown in Figure 5.

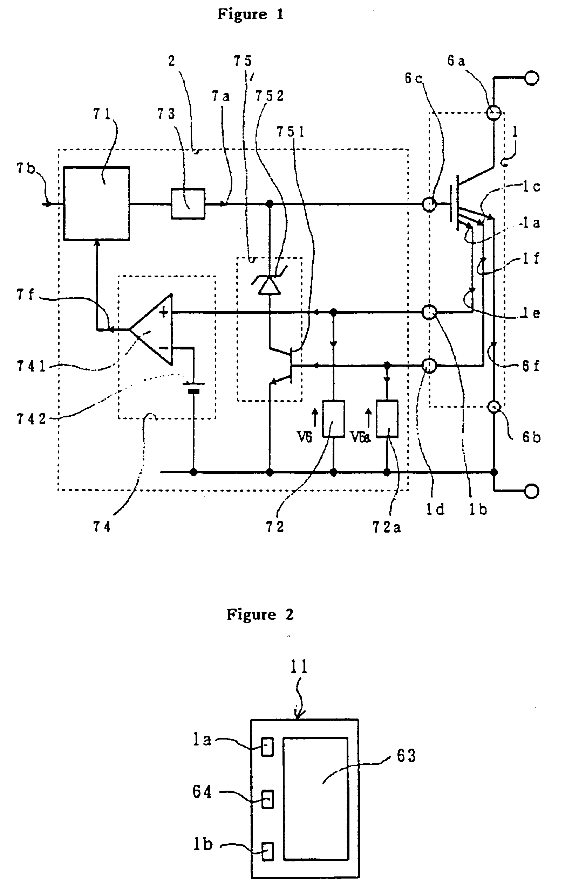

The embodiments of the present invention will now be explained with reference to Figures 1 to 3 of the appended drawings.

Referring now to Figure 1, there is seen a circuit diagram of the relevant part of a first embodiment of the semiconductor device. In Figure 1, those parts which are identical with parts of the conventional semiconductor arrangement shown in Figure 5 are given the same numbers, and their relevant explanations are omitted for brevity.

In Figure 1, an IGBT 1 with a current-sensing function, which is one example of a semiconductor element with a current-sensing function, has a control circuit 2.

The IGBT 1 includes a collector terminal 6a as a first main electrode, an emitter terminal 6b as a second main electrode, a gate terminal 6c as a control electrode, and an output terminal 1b for a first current-sensing electrode 1a, as well as an output terminal 1d for a second current-sensing electrode 1c. This IGBT turns the device on and off according to the drive signal 7a received from a control circuit 2, causing a main current 6f to flow from the first main electrode terminal 6a to the second main electrode terminal 6b when the device is turned on, and turns the main current 6f off when the drive signal 7a switches to a turn-off signal.

When the main current 6f flows into the IGBT 1, the sensing currents 1e and 1f, which have values proportional to the main currents 6f, flow out from the first current sensing electrode la and the second current sensing electrode 1c, and these currents are led from the output terminals 1b and 1d externally of the IGBT 1.

Figure 2 is a plan view showing the construction of the aforementioned IGBT 1. As shown in Figure 2, the IGBT 1 has an emitter 63 with a large area formed on the surface of a semiconductor substrate 11. The surface on which this emitter is formed also has thereon a gate 64 and a first current-sensing electrode 66, as well as a second current-sensing electrode 67 with a substantially smaller area than that of the emitter 63. The collector is formed, as before, on the face opposite to the face on which the emitter 63 is located.

The control circuit 2 has a first current-sensing resistor 72 added to the conventional control circuit 7 shown in Figure 5. The current-sensing resistor 72 generates a detection voltage V6, which is proportional to the flowing sensing current 1e, and is consequently proportional to the main current 6f. This detection voltage is applied to a comparator 741 in the main current turn-off command circuit 74.

A second current-sensing resistor 72a, which has a resistance value Rsa generates a second detection voltage V6a which is proportional to the flowing sensing current 1f, and is consequently proportional to the main current 6f. This second detection voltage V6a is applied to the base of the NPN transistor 751 in the main current control circuit 75.

If the value of the second detection voltage V6a exceeds the threshold voltage V th of the transistor 751, this transistor turns on, and the voltage between the gate terminal 6c and the emitter terminal 6b of the IGBT 1 is reduced to the Zener voltage value of the constant voltage diode 752.

In the above-described circuitry, if the signal 7a sent to the IGBT 1 is a turn-on command signal, and the value of the main current 6f increases for some reason and reaches the value I oc of the overcurrent detection level, thereby causing the value of the detection voltage V6 generated by the first current-sensing resistor 72 to reach its reference voltage E1, the main current turn-off command circuit 74 detects this condition and applies an output signal 7f to the drive circuit 71. The drive circuit 71 which receives this signal 7f then converts this output signal 7a to a low L level signal, and forces the IGBT 1 off.

In addition, if the value of the main current 6f increases abruptly because of a short-circuit failure and reaches the value I sct of the short-circuit current detection level, then the value of the second detection voltage V6a detected by the second current-sensing resistor 72a reaches the threshold voltage V th, and the transistor 751 turns on and the main current 6f decreases rapidly to a value that the IGBT 1 can tolerate.

In this case, the following formulae 3 and 4 can be expressed with respect to the current values I oc and I sct at their respective current detection levels:$\text{I oc = (N) (E1)/Rs}$$\text{I sct = (N) (V th)/Rsa}$

In the formulae, these two resistance values Rs and Rsa are the values found in the first and second current-sensing resistors 72 and 72a respectively, and they can be set independently of each other. Therefore, the current values I oc and I sct can also be set independently of each other.

This means that the ratio between the current values, I oc/I sct, can be varied by properly selecting the ratio between the resistance values, Rsa/Rs, even after the reference voltage E1 and threshold voltage V th have been determined.

If a smooth protective operation can be performed even when the current value ratio, I oc/I sct, is the same as the voltage ratio, E1/V th, the resistance values, Rs and Rsa, can be made identical.

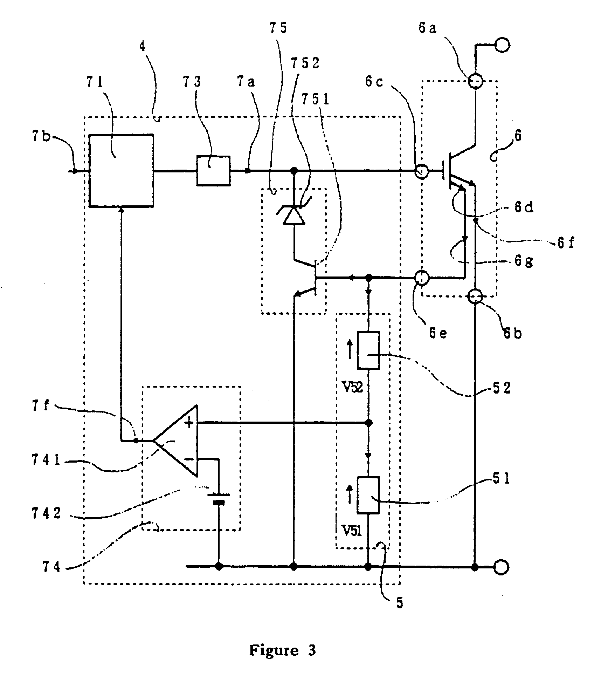

Turning to Figure 3, there is seen a circuit diagram for the relevant part of a second embodiment of the semiconductor device. In Figure 3, the parts identical to those of the conventional semiconductor shown in Figure 5 are given the same numbers, and their explanations are omitted.

In Figure 3, the control circuit 4 for the IGBT 6 is disposed with a current-sensing resistor 5, which is different from the current-sensing resistor 72 used in conventional control circuits 7.

The current-sensing resistor 5 is constituted by two resistors 51 and 52 connected in series, and having resistance values of Rs51 and Rs52 respectively. When the sensing current 6g flows into this resistor 5 from the IGBT 6, the voltage drops V51 and V52 in proportion to the main current 6f are generated at the unit resistors 51 and 52.

The voltage drop V51 is then applied to the comparator 741 in the main current turn-off command circuit 74 as a detection voltage of the main current 6f.

The total of the voltage drops V51 and V52 is also applied to the base of the NPN transistor 751 in the main current control circuit 75 as the detection voltage of the main current 6f.

In the above-described circuitry, if the signal 7a sent to the IGBT 6 is a turn-on command signal, and the value of the main current 6f increases for some reason and the sensing current 6g reaches the value I oc of the overcurrent detection level, and the value of the detection voltage V51 according to the current-sensing unit resistor 51 reaches its reference voltage E1, the main current turn-off command circuit 74 detects this condition and applies a signal 7f to the drive circuit 71. The drive circuit 71 receiving the signal 7f converts this output signal 7a into a low-level L signal, and forces the IGBT 6 off.

Likewise, if the value of the main current 6f increases abruptly because of a short-circuit failure and the sensing current 6g reaches the value I sct of the short-circuit current detection level, and the value of the detection voltage detected at the current-sensing resistor 5, that is a total of the voltage drops V51 and V52, reaches the threshold voltage V th, then the transistor 751 turns on, and the main current 6f rapidly decreases to a value that the IGBT 6 can tolerate.

In this case, the following formulae 5 and 6 can be expressed with respect to the current values I oc and I sct at the respective current detection levels:$\text{I oc = (N) (E1)/Rs51}$$\text{I sct = (N) (V th)/(Rs51 + RS52)}$

In these formulae, the two resistance values Rs51 and Rs52 represent the resistance values in the two resistors 51 and 52, respectively, which can be set independently of each other. Therefore, the current values I oc and I sct can also be set independently of each other.

This means that the ratio between the current values, I oc/I sct, can be varied by properly selecting the ratio between the resistance values, (Rs51 + Rs52)/Rs51, even after the reference voltage E1 and threshold voltage V th have been determined.

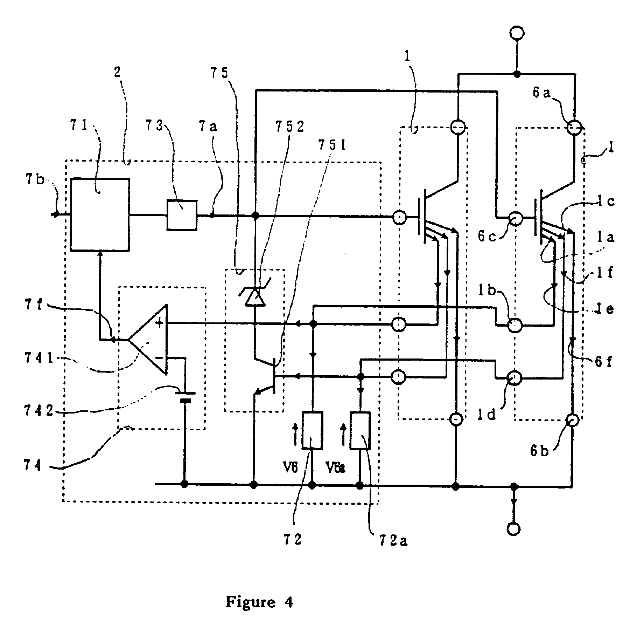

Referring now to Figure 4, there is seen a circuit diagram of the relevant part of a third semiconductor device according to the invention. In Figure 4, the parts identical to the parts of the conventional semiconductor arrangement shown in Figure 5 are given the same numbers, and their explanations are omitted.

The semiconductor device shown in Figure 4 differs from the aforementioned semiconductor device, which is shown in Figure 1, in that the semiconductor device of Figure 4 has two IGBTs 1.

The two IGBTs 1 have their corresponding terminals 6a, 6b, 6c, 1b and 1d respectively connected to each other.

Therefore, the first current-sensing resistor 72 generates a first detection voltage V6 which is proportional to the total of the main currents 6f in the two IGBTs when the sum of the sensing currents 1e from the IGBTs 1 flows in.

Furthermore, the second current-sensing resistor 72a generates the second detection voltage V6a that is in proportion to the total of the main currents 6f in the IGBTs when the sum of the sensing currents 1f from the two IGBTs 1 flows in.

The roles of the detection voltages V6 and V6a are identical to those of the semiconductor device shown in Figure 1.

Now, when the current values, I oc and I sct, at the current detection levels relative to the IGBTs are referred to as I oca and I ocb and as I scta and I sctb respectively, the following formulae 7 and 8 can be expressed:$\text{I oca + I ocb = (N) (E1)/Rs}$$\text{I scta + I sctb = (N) (V th)/Rsa}$

In these formulae, the two resistance values Rs and Rsa represent the resistance values in the first and second current-sensing resistors 72 and 72a, respectively. These values can be set independently of each other. Therefore, the current values (I oca + I ocb) and (I scta + I sctb) can also be set independently of each other.

This means that the IGBTs with current-sensing function connected in parallel are protected against excessive main currents, that is, not against individual main currents but against the total main current. The ratio between the current values, (I oca + I ocb)/(I scta + I sctb) can therefore be varied by properly selecting the ratio between the resistance values, Rsa/Rs, even after the reference voltage E1 and threshold voltage V th have been determined.

According to the above explanation, referring to Figure 4, two IGBTs are connected in parallel. However, this number should not be limited to this example, since there may be three or more parallel connections.

In addition, the IGBTs which have a main current-sensing function have been shown to have various current-sensing electrodes. However, the present invention should not be limited to this construction, but there need be only one current-sensing electrode for each IGBT as seen in the embodiment of Figure 3, and the electrodes may be connected in common, while only one current-sensing resistor need be disposed for each electrode connected in common.

Furthermore, the IGBT described above is a semiconductor element with current-sensing function. However, a transistor of another type, such as a MOSFET with current-sensing function for example, may also be used.

As described above, according to the present invention, either by disposing various current-sensing electrodes on a semiconductor element with a current-sensing function wherein signals corresponding to the sensing currents derived from each current-sensing electrode are applied independently into the main current turn-off command circuit and main current control circuit in a control circuit for the semiconductor element, or by constructing the current-sensing resistor in the control circuit with various unit resistors connected in series wherein a single sensing current flows into this resistor to generate various detection voltages divided by the resistor while detection voltages with different values are inputted independently into the main current turn-off command circuit and main current control circuit, the value I oc of the overcurrent detection level for the semiconductor element with a current-sensing function and the value (I sct) at the short-circuit current detection level can be set independently of each other.

Therefore, while increasing I oc, setting I sct within a short-circuit current withstand capacity of the semiconductor element, and extending the upper limit in the main current of the semiconductor element, it is possible to avoid element breakdown due to a short-circuit current.

If a plurality of semiconductor elements with a current sensing function are connected in parallel the same effect as described above can be achieved by connecting the corresponding current-sensing electrodes of these semiconductor elements in parallel to generate various detection voltages with a total current, which can be derived from the sensing electrodes, flowing into the current sensing resistors, and applying detection voltages with different values independently into the main current turn-off command circuit and main current control circuit.

## Claims

1. A semiconductor device, comprising a semiconductor element (1, 6) with a current-sensing function and having two main electrodes (6a, 6b), a control electrode (6c), and a current-sensing electrode (1b, 1d, 6e) and wherein the value of the main current (6f) flowing from one main electrode (6a) to the other (6b) is controlled by a signal applied into the control electrode (6c), and a sensing current (6g) corresponding to the value of the main current (6f) is led away from the current sensing electrode (1b, 1d, 6e),
a control circuit consisting of:
a current-sensing resistor 72 to generate a detection voltage (V6) which is proportional to the current value of the sensing current (6g),
a main current turn-off command circuit (74) which uses a sensing current detection voltage as an input, and outputs a turn-off command signal (7f) for the main current when the value thereof exceeds a predetermined level,
a drive circuit to emit to the control electrode (6c) in the semiconductor element (1, 6) a signal (7a) to control the value of the main current (6f), and upon receiving the turn-off command signal from the main current turn-off command circuit (74), to emit the output signal after converting it into a signal that will turn the main current (6f) off, and a main current control circuit (75) which uses the detection voltage of the sensing current (6g) as an input, and controls the voltage between the control electrode (6c) and the other main electrode (6b) when the value thereof exceeds its predetermined level,
characterised in that the semiconductor element (1) is provided with various current-sensing electrodes (1b, 1d), and in that
detection voltages of the sensing currents (1e, 1f) obtained by flowing sensing currents (1e, 1f) from the different current-sensing electrodes (1b, 1d) of the semiconductor device (1) into different current-sensing resistors (72, 72a) are independently applied to the main current turn-off command circuit (74) and the main current control circuit (75).

2. A semiconductor device, comprising a semiconductor element (1, 6) with a current-sensing function and having two main electrodes (6a, 6b), a control electrode (6c), and a current-sensing electrode (1b, 1d, 6e) and wherein the value of the main current (6f) flowing from one main electrode (6a) to the other (6b) is controlled by a signal applied into the control electrode (6c), and a sensing current (6g) corresponding to the value of the main current (6f) is led away from the current sensing electrode (1b, 1d, 6e),
a control circuit consisting of:
a current-sensing resistor 72 to generate a detection voltage (V6) which is proportional to the current value of the sensing current (6g),
a main current turn-off command circuit (74) which uses a sensing current detection voltage as an input, and outputs a turn-off command signal (7f) for the main current when the value thereof exceeds a predetermined level,
a drive circuit to emit to the control electrode (6c) in the semiconductor element (1, 6) a signal (7a) to control the value of the main current (6f), and upon receiving the turn-off command signal from the main current turn-off command circuit (74), to emit the output signal after converting it into a signal that will turn the main current (6f) off, and a main current control circuit (75) which uses the detection voltage of the sensing current (6g) as an input, and controls the voltage between the control electrode (6c) and the other main electrode (6b) when the value thereof exceeds its predetermined level,
characterised in that the current-sensing resistor (5), which has various unit resistors (51, 52) connected in series generates various detection voltages (V51, V52) with values that differ according to the sensing current,
these detection voltages (V51, V52) with different values are independently applied to the main current turn-off command circuit (74) and the main current control circuit (75).

3. A semiconductor device as claimed in Claim 1 or 2, characterised in that, when semiconductor elements (1, 6) with a current-sensing function are connected in parallel, the current-sensing electrodes (6e, 1b, 1d) corresponding to these semiconductor elements (1, 6) are also connected in parallel, and a current (6g) that is the total of the sensing currents coming from each electrode (6e, 1b, 1d) flows into the current-sensing resistor (51, 52, 72, 72a) oE the control circuit (2).
